Europäisches Patentamt

European Patent Office

Office européen des brevets

(11) Publication number: **0 253 126 B1**

# EUROPEAN PATENT SPECIFICATION

(45) Date of publication of patent specification: **20.05.92**   (51) Int. Cl.⁵: **H01L 23/36**

(21) Application number: **87108173.3**

(22) Date of filing: **05.06.87**

(54) **Heat sink.**

(30) Priority: **19.06.86 US 876054**

(43) Date of publication of application:
**20.01.88 Bulletin 88/03**

(45) Publication of the grant of the patent:
**20.05.92 Bulletin 92/21**

(84) Designated Contracting States:
**DE FR GB**

(56) References cited:
**CA-A- 1 026 013**
**DE-A- 1 789 156**
**US-A- 2 984 774**
**US-A- 4 541 004**

**PATENT ABSTRACTS OF JAPAN, vol. 7, no. 40 (E-159)[1185], 17th February 1983; & JP - A - 57 193 049**

**IBM TECHNICAL DISCLOSURE BULLETIN, vol. 23, no. 2, July 1980, pages 603-604, New York, US; J. HORVATH "Cooling fin structure"**

(73) Proprietor: **International Business Machines Corporation**
**Old Orchard Road**
**Armonk, N.Y. 10504(US)**

(72) Inventor: **Arnold, Allen Joseph**
**Box 335, RR 2, Andrews Road**
**Lagrangeville New York 12540(US)**
Inventor: **Sutton, Kerry Louis**
**75 Fieldstone Boulevard**
**Wappingers Falls New York 12540(US)**

(74) Representative: **Klocke, Peter, Dipl.-Ing.**
**IBM Deutschland GmbH Patentwesen und Urheberrecht Schönaicher Strasse 220**
**W-7030 Böblingen(DE)**

## Description

This invention relates to a heat sink for cooling modules containing semiconductor chips.

As the density of very large scale integrated (VLSI) circuits continues to increase, the amount of heat generated also increases and becomes more of a problem. In air cooled semiconductor modules, cooling is facilitated by the use of fins of heat conducting material to increase the surface area for radiating heat to the air. Examples of such structures can be found in the IBM Technical Disclosure Bulletin, "Cooling Fin Structure" by J. L. Horvath, Vol. 23, No. 2, July 1980, page 603.

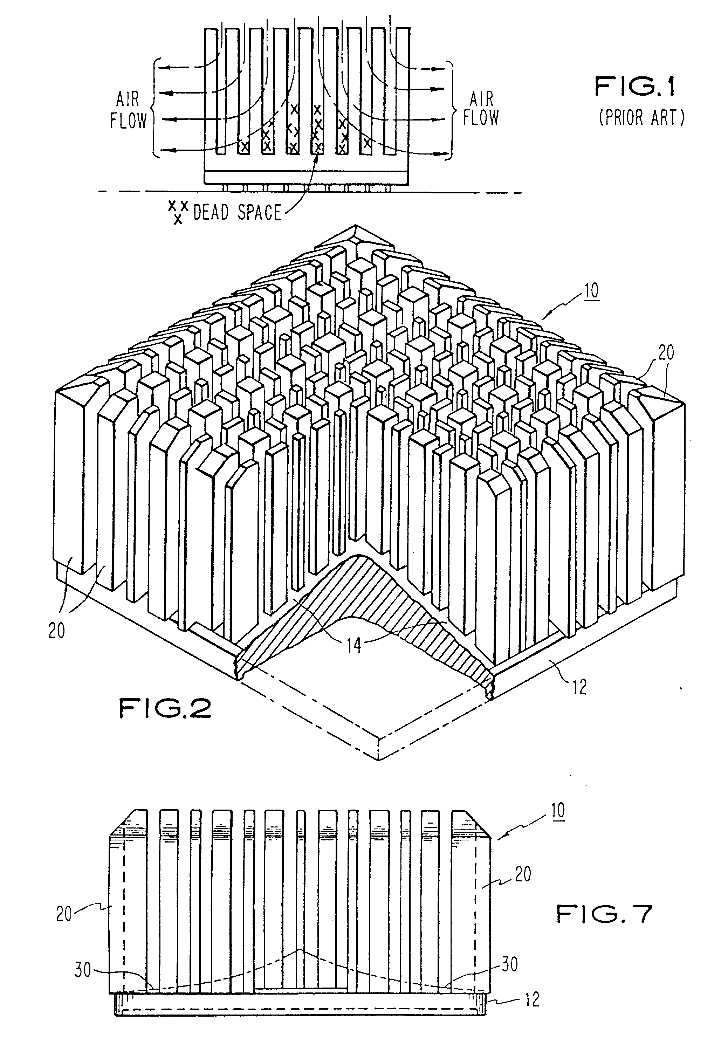

This structure consists of a network of vertical, serpentine fins mounted on a base element, typically a cover for a semiconductor package. Since the base element is flat, this cooling structure is effective in both transverse and impingement air flow. However, this design is inefficient during impingement air flow since the air parts as it hits the surface, thereby creating a dead space near the top surface of the heat sink (Fig. 1). The presence of this dead space limits the cooling efficiency of the heat sink.

While in the past, this limitation has not been a problem, this is no longer the case. Circuit densities have increased so greatly that any limitation in heat transfer can no longer be tolerated. Accordingly, it is desirable to have a heat sink suitable for cooling a semiconductor module with a vertical impingement air flow that maximizes the cooling efficiency by eliminating the dead space.

The invention as claimed provides an improved heat sink for modules containing semiconductor chips. The heat sink includes a base of heat conductive material, the top surface of said base has a peak to reduce the dead space that would otherwise occur during vertical impingement air flow. Extending from the top surface of the base are a plurality of vertical cooling fins, also made from a highly heat conductive material. In the preferred embodiment, the top surface is pyramidal in shape, with four triangular surfaces meeting in a peak at the center. In other embodiments, the top surface can have other shapes, such as convex or concave curves. Further, the peak does not have to be located at the center, but should be located at the optimal position for enhanced air flow, which is determined by the air flow dynamics of the environment. Also, in another embodiment, webs of material can be left at the bottom of the cooling fins to provide channels for improved air flow.

The invention is described in detail below in connection with the drawings in which:

Fig. 1    is a side view of a heat sink as known in the prior art.

Fig. 2    is a perspective view of the heat sink in accordance with this invention.

Fig. 3    is a top view of the heat sink in accordance with this invention.

Fig. 4    is a side view of the heat sink in accordance with this invention.

Fig. 5    is a top view of the heat sink with webbed fins.

Fig. 6    is a side view of the heat sink with webbed fins.

Fig. 7    is a side view of an alternative embodiment of the heat sink in accordance with this invention.

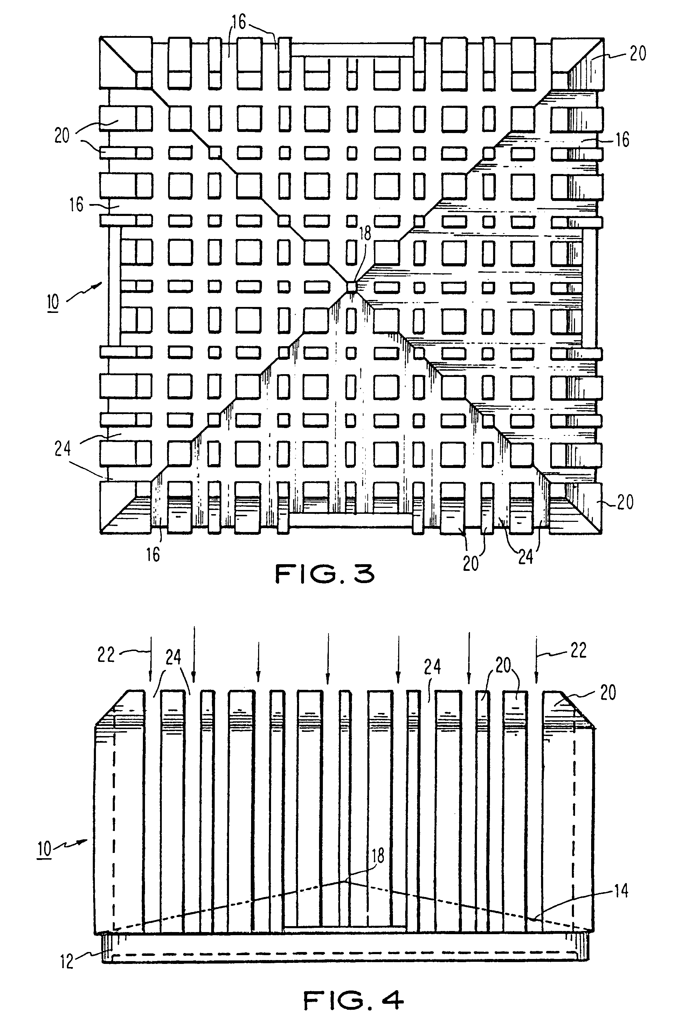

Referring to Figs. 2 and 3, heat sink 10 has a base 12 fabricated from a heat conducting material such as aluminum, copper, alloys of each, etc. In the preferred embodiment, top surface 14 is pyramidal in shape, having four triangular planar surfaces 16 which meet at peak 18. Extending vertically from the top surface 14 are a plurality of cooling fins 20. Cooling fins 20 increase the surface area for the conduction of heat from a semiconductor module (not shown) to the ambient air. The shape, size and spacing of the cooling fins 20 are not critical to this invention and can be selected to optimize the heat transfer in a specific environment. Peak 18 is shown at the center of heat sink 10, but can be designed off-center, if desired, to maximize the air flow through the heat sink.

Impingement air flow, directed from above, is shown by arrows 22 in Fig. 4. As the cooling air flows through channels 24 between cooling fins 20, it will deflect, or part, and flow towards the periphery of the heat sink. As the air travels toward the periphery in contact with the surface 14, more heat will be absorbed, further increasing the cooling efficiency. As stated in the Background section, the peak 18 and pyramidal shaped top surface 14, eliminate the "dead space" near the center of the heat sink which would occur if the top surface were flat. Studies have demonstrated a 12 percent gain in cooling efficiency by the elimination of the "dead space."

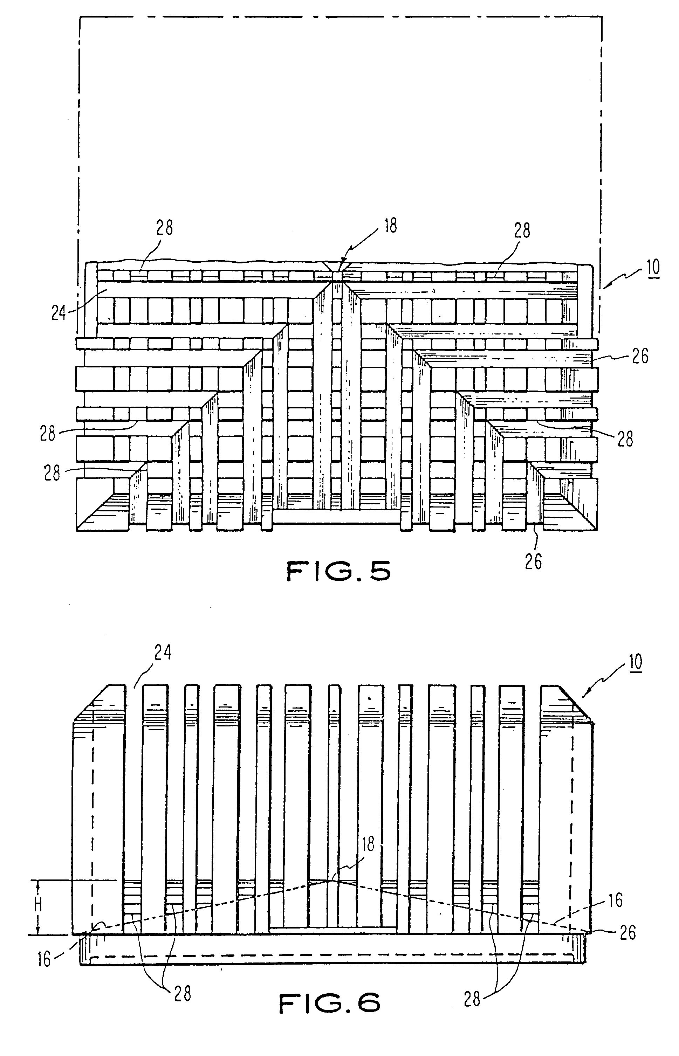

The fabrication of the heat sink in accordance with this invention can be done using manufacturing processes well-known in the art such as milling, casting, etc. When using milling, or cutting processes, an additional, unexpected improvement in cooling efficiency can be realized. For example, a solid block of aluminum is first cut to size (Figs. 5 and 6). Then, each of the four triangular planar surfaces 16 is cut individually from the bottom edges 26 of the heat sink 10 sloping upwards toward where the peak 18 is desired. When all four planar surfaces 16 have been cut, webbed fins 28 will remain within some of the channels 24. The height of the webbed fins 28 will vary from height H at the periphery to zero at the peak due to the slanted surfaces 16. These webbed fins 28 direct the air flow through the heat sink 10, further increasing its cooling efficiency.

## Claims

1. A heat-sink (10) for cooling modules containing semi-conductor chips comprising
a base (12) of heat-conducting material, said base including a bottom surface and a top surface (14), said top surface having a plurality of vertical cooling fins (20) extending from said top surface
characterized in that
said top surface has a peak which is located at the optimal position for reducing the dead space during vertical impingement air flow.

2. The heat sink as claimed in Claim 1 wherein said top surface is comprised of at least three planar portions.

3. The heat sink as claimed in Claim 1 wherein said top surface is comprised of four planar portions.

4. The heat sink as claimed in any of Claims 1-3 further comprising a plurality of webbed fins between said cooling fins to channel the air flow over said top surface.

5. The heat sink as claimed in any of Claims 2-3 in which said planar portions are replaced by concave-shaped portions.

6. The heat sink as claimed in any of Claims 2-3 in which said planar portions are replaced by convex-shaped portions.

7. Use of a heat sink according to Claims 1-7 for cooling modules containing semiconductor chips.

## Revendications

1. Puits thermique (10) pour le refroidissement de modules contenant des puces semi-conductrices, qui comprend
une base (12) en matière conductrice de la chaleur, ladite base présentant une surface inférieure et une surface supérieure (14), ladite surface supérieure portant une pluralité d'ailettes de refroidissement verticales (20) qui s'étendent à partir de ladite surface supérieure,
caractérisé en ce que
ladite surface supérieure présente une crête qui est située à la position optimale pour réduire l'espace mort pendant une circulation d'air à incidence verticale.

2. Puits thermique suivant la revendication 1, dans lequel ladite surface supérieure est constituée d'au moins trois parties planes.

3. Puits thermique suivant la revendication 1, dans lequel ladite surface supérieure est constituée de quatre parties planes.

4. Puits thermique suivant l'une quelconque des revendications 1 à 3, comprenant en outre une pluralité d'ailettes feuilletées entre lesdites ailettes de refroidissement, pour canaliser l'écoulement d'air sur ladite surface supérieure.

5. Puits thermique suivant l'une quelconque des revendications 2 et 3, dans lequel lesdites parties planes sont remplacées par des parties concaves.

6. Puits thermique suivant l'une quelconque des revendications 2 et 3, dans lequel lesdites parties planes sont remplacées par des parties convexes.

7. Utilisation d'un puits thermique suivant les revendications 1 à 7 pour le refroidissement de modules contenant des puces semi-conductrices.

## Patentansprüche

1. Ein Kühlkörper zur Kühlung von Modulen, die Halbleiterchips enthalten, bestehend aus einer Basis (12) aus wärmeleitendem Material, wobei die Basis eine Bodenfläche und eine obere Fläche (14) beinhaltet und die obere Fläche eine Vielzahl von vertikalen Kühlrippen aufweist, die von dieser oberen Fläche abstehen, dadurch gekennzeichnet,
daß die obere Fläche einen Vorsprung aufweist, der sich an der optimalen Position befindet, um den toten Raum bei vertikalem Einstrom von Luft zu verringern.

2. Ein Kühlkörper nach Anspruch 1, wobei die obere Fläche aus mindestens drei ebenen Anteilen gebildet wird.

3. Ein Kühlkörper nach Anspruch 1, wobei die obere Fläche aus mindestens vier ebenen Anteilen gebildet wird.

4. Ein Kühlkörper nach einem der Ansprüche 1 - 3, wobei zusätzlich eine Vielzahl von vernetzten Stegen zwischen den Kühlrippen verlaufen, um den Luftstrom über die obere Fläche zu kanalisieren.

5. Ein Kühlkörper nach einem der Ansprüche 2 - 3, wobei die ebenen Flächenanteile durch konkav geformte Anteile ersetzt sind.

6. Ein Kühlkörper nach einem der Ansprüche 2 - 3, wobei die ebenen Flächenanteile durch konvex geformte Anteile ersetzt sind.

7. Die Anwendung des Kühlkörpers nach einem der Ansprüche 1 - 7 zur Kühlung von Modulen die Halbleiterchips enthalten.

**FIG.1**
(PRIOR ART)

AIR
FLOW

AIR
FLOW

ˣˣˣ DEAD SPACE

10

20

20

14

12

**FIG.2**

10

20

20

30

30

12

**FIG.7**

FIG. 3

FIG. 4

**FIG.5**

**FIG.6**